## Europäisches Patentamt
## European Patent Office
## Office européen des brevets

(19)

(11) Numéro de publication : **0 037 885**
**B1**

(12)

# FASCICULE DE BREVET EUROPÉEN

(45) Date de publication du fascicule du brevet :
**25.07.84**

(21) Numéro de dépôt : **81101077.6**

(22) Date de dépôt : **16.02.81**

(51) Int. Cl.³ : **H 02 H 3/08**, H 02 H 3/00,
G 01 R 19/165

(54) **Circuit de détection de courant de défaut.**

(30) Priorité : **10.04.80 FR 8008341**

(43) Date de publication de la demande :
**21.10.81 Bulletin 81/42**

(45) Mention de la délivrance du brevet :
**25.07.84 Bulletin 84/30**

(84) Etats contractants désignés :
**DE FR GB IT**

(56) Documents cités :
**FR-A- 2 344 159**
**US-A- 3 626 262**
**US-A- 3 979 255**

(73) Titulaire : **International Business Machines Corporation**
**Old Orchard Road**
**Armonk, N.Y. 10504 (US)**

(72) Inventeur : **Rice, Anthony; John**
**Chemin des Colles**
**F-06610 La Gaude (FR)**

(74) Mandataire : **Lattard, Nicole**
**Compagnie IBM France Département de Propriété Industrielle**
**F-06610 La Gaude (FR)**

EP 0 037 885 B1

Jouve, 18, rue St-Denis, 75001 Paris, France

## Description

### Domaine technique

La présente invention concerne un circuit de détection de courant de défaut dont le seuil de détection est auto-ajustable et qui en conséquence convient bien pour la protection de machines.

Par exemple, dans un système d'alimentation de puissance qui fournit un courant pour alimenter une charge, une condition de défaut dans la charge fait qu'un supplément de courant que l'on peut appeler courant de défaut est tiré de l'alimentation. Ce courant supplémentaire provoque des court-circuits qui étant des défauts supplémentaires font encore augmenter le courant de défaut.

### Art antérieur

En conséquence, il est nécessaire d'inclure à la sortie de l'alimentation de puissance, un dispositif de protection qui empêche le courant de défaut d'augmenter afin qu'il n'atteigne pas la limite pour laquelle la somme des courants de charge et de défaut est égale au courant maximum que peut fournir l'alimentation.

Généralement, pour les alimentations de puissance délivrant un courant supérieur à 20 ampères, on utilise un disjoncteur qui déclenche à partir d'un seuil fixe.

Cette solution ne peut pas s'appliquer dans une machine où la charge à alimenter n'est pas toujours la même et dépend de l'utilisateur. Par exemple dans un système de télétraitement comprenant un contrôleur de communication dont un type d'architecture est décrit dans la figure 1 de la demande de brevet européen publiée sous le numéro 0 005 722, un bloc d'alimentation de puissance est utilisé pour un ou plusieurs adaptateurs de lignes. En conséquence, suivant la configuration du réseau, c'est-à-dire suivant le nombre de terminaux, la charge du bloc d'alimentation varie dans des proportions importantes allant de 1 à 4. Dans ces conditions, la protection ne peut pas être assurée de façon satisfaisante pour toutes les configurations du réseau.

Une solution à ce problème consiste à mesurer le courant de charge à l'installation de la machine et à régler manuellement le point de déclenchement du disjoncteur. Mais ceci complique les procédures d'installation et amène une source d'erreur humaine supplémentaire et en conséquence n'est guère satisfaisant.

Les seuils de détection peuvent aussi être réglés automatiquement par programme comme décrit dans la publication IBM Technical Disclosure Bulletin, Vol. 20, No 9, February 1978, page 3589. Cette possibilité ne peut bien entendu être utilisée que dans des machines comprenant des microprocesseurs et complique aussi, dans de telles machines, les procédures de mise en fonction, puisqu'il faut en plus de toutes les opérations généralement nécessaires, se préoccuper des valeurs limites à choisir, les charger en mémoire, ce qui en conséquence nécessite une intervention de l'installateur.

### Brève description de l'invention

La présente invention concerne un circuit de détection de courant de défaut à seuil auto-réglable selon la partie caractérisante de la revendication 1. Un tel circuit de détection permet d'assurer la protection de machines à configuration évolutive.

Conformément à l'invention, le circuit de détection comprend des moyens pour générer une première tension proportionnelle au courant fourni par l'alimentation et des moyens qui fonctionnent pendant une période d'initialisation pour générer une seconde tension égale à la valeur initiale de la première tension et dériver de cette seconde tension une tension de seuil qui sera utilisée comme seuil de détection de courant en période de fonctionnement. Pendant la période d'initialisation la protection est assurée par un circuit de détection à seuil fixe, qui fonctionne avec une tension de référence.

Grâce à ce circuit, le seuil de détection est réglé dès la fin de la période d'initialisation en fonction de la charge à alimenter et en conséquence il s'adapte à chaque configuration de la machine.

D'autres objets, caractéristiques et avantages de la présente invention ressortiront mieux de l'exposé qui suit, fait en référence aux dessins annexés à ce texte, qui représentent un mode de réalisation préféré de celle-ci.

### Brève description des figures

La figure 1 représente schématiquement une installation d'alimentation d'une machine explicitant le problème à résoudre.

La figure 2 représente le circuit de détection à seuil auto-ajustable conforme à la présente invention.

La figure 3 représente un diagramme des temps des tensions en certains points du circuit de la figure 2.

La figure 4 représente un graphique permettant de faire la comparaison entre les protections assurées par le circuit de la présente invention et les circuits de l'art antérieur.

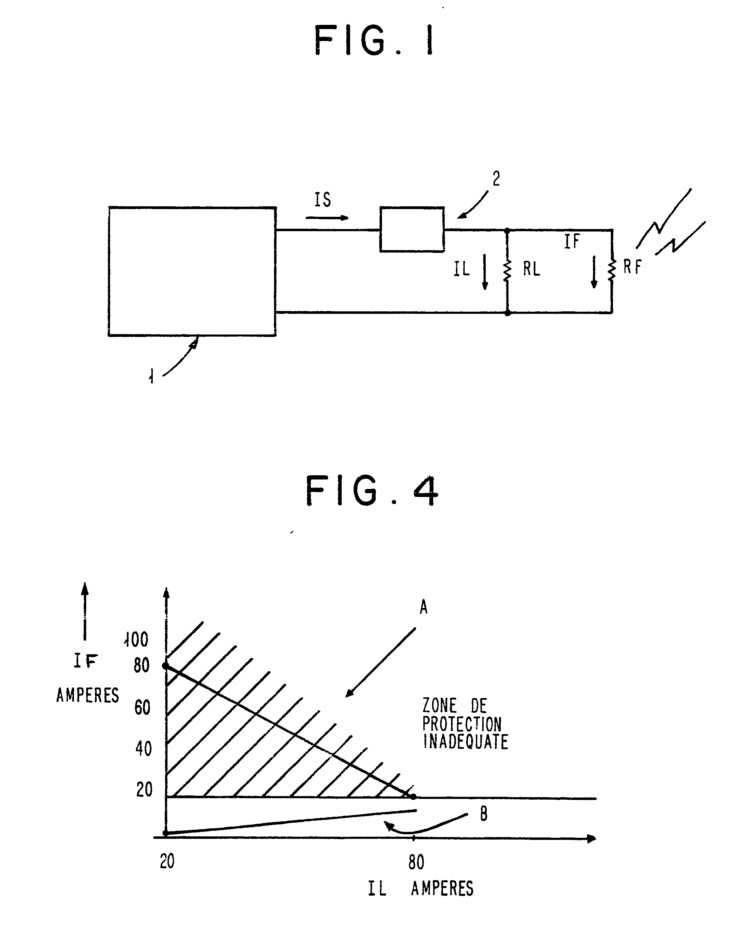

La figure 1 illustre de façon très schématique le problème à résoudre par le circuit de la présente invention. Une alimentation de puissance 1 délivrant une tension fixe, fournit un courant IS à une charge utile, qui peut être constituée par tout ou partie d'une machine. La charge est représentée par une résistance RL qui tire un courant de charge IL. Lorsqu'il se produit certaines conditions de défaut dans la charge, par exemple, claquage d'une capacité ou court-circuit, un courant supplémentaire de défaut schématisé par IF sur la figure est tiré de l'alimentation. La chaleur dissipée par suite de ce courant supplémentaire peut provoquer des conditions de pannes qui feront encore augmenter ce courant IF, jusqu'à ce que

$$IL + IF = IS$$

IS étant le courant maximum que peut fournir l'alimentation.

Afin de limiter IF, il faut placer dans le circuit un circuit de protection 2 qui disjoncte pour un courant de seuil.

Dans une installation où la charge peut varier suivant la configuration de la machine, et où le courant IS maximum est élevé, on ne peut utiliser de circuit de protection à seuil fixe comme on va le démontrer.

Dans le cas d'un bloc d'alimentation fournissant un courant de fonctionnement de 80 Ampères, on peut supposer que suivant la configuration de la machine installée, dans le cas d'un réseau de télétraitement, suivant le nombre des terminaux du réseau, le courant de charge peut varier entre 20 et 80 Ampères. En conséquence, si le bloc d'alimentation peut fournir un courant de sortie maximum de 100 Ampères, le courant de déclenchement doit être réglé à 100 Ampères en conséquence suivant la charge, le courant IF variera entre 20 Ampères et 80 Ampères.

Si un courant de défaut de 20 Ampères s'avère satisfaisant, dans le cas de la configuration maximum où IL = 80 A, un courant de défaut de 80 Ampères, dans le cas de la configuration minimum où IL = 20 A provoquerait beaucoup trop de dégât pour être toléré.

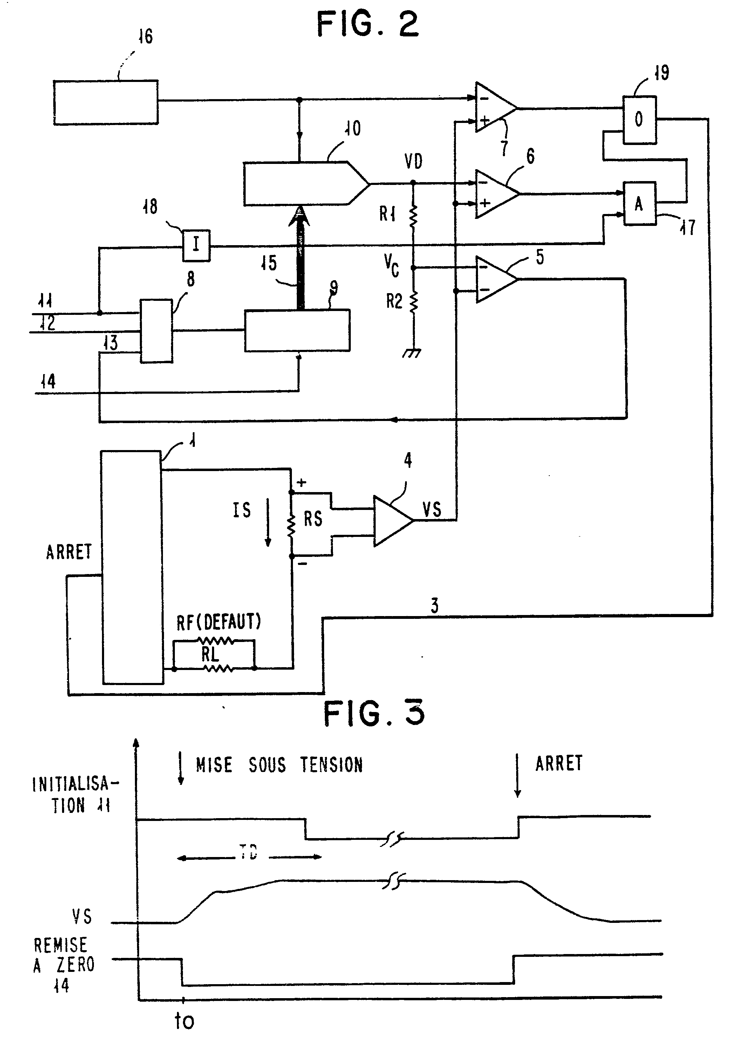

En conséquence, le circuit représenté sur la figure 2 permet d'assurer une protection adéquate quelle que soit la configuration de la machine. Le circuit permet une initialisation automatique du seuil de détection, chaque fois que la machine est mise sous tension.

Sur la figure 2 on a représenté schématiquement l'alimentation 1, et la charge variable RL, qui sont les éléments de la figure 1. Le circuit de détection conforme à la présente invention génère un signal de commande sur la ligne 3 pour arrêter l'alimentation dans le cas où une condition de défaut est détectée ce qui provoque l'arrêt de la machine.

Une résistance RS est placée dans le circuit d'alimentation et un amplificateur différentiel 4 est placé aux bornes de cette résistance pour fournir en sortie une tension VS proportionnelle au courant IS, sans modifier ce courant de façon sensible.

Cette tension VS est appliquée aux trois entrées +, de trois comparateurs 5, 6, 7. Un circuit logique comprenant une porte ET 8, un compteur 9, un convertisseur numérique/analogique 10, fournit à la sortie du convertisseur 10, l'entrée au comparateur 6. Un pont de résistances R1, R2 est connecté entre la sortie du convertisseur 10, et la masse, le point commun des résistances R1 et R2 constitue l'entrée − du comparateur 5.

Le circuit ET 8 a trois entrées, une première entrée 11, reçoit un signal d'initialisation, une seconde entrée 12 reçoit un signal d'horloge, et la troisième entrée 13 est connectée à la sortie du comparateur 5. La sortie du circuit 8 fournit le signal de commande au compteur 9. Le compteur 9 est remis à zéro par un signal sur la ligne 14. Le bus de sortie 15 du compteur est relié aux entrées du convertisseur numérique/analogique 10.

Le comparateur 7 reçoit sur son entrée −, une tension de référence VR qui est fournie par un générateur 16. Cette tension de référence VR est aussi utilisée par le convertisseur 10.

Une porte ET 17 reçoit sur une de ses entrées la sortie du comparateur 6, et sur son autre entrée le signal d'initialisation inversé par l'inverseur 18. La sortie de la porte ET 17 est connectée à une entrée de la porte OU 19 dont l'autre entrée est reliée à la sortie du comparateur 7. La sortie de la porte OU 19 fournit le signal de commande sur la ligne 3 qui coupe l'alimentation quand une condition de défaut est détectée.

Tous les éléments du circuit sont classiques et couramment utilisés dans les dispositifs électroniques, en conséquence, ils ne seront pas décrits en détail.

Le fonctionnement du dispositif de détection est le suivant. A la mise sous-tension, le courant IS et par suite la tension VS vont augmenter progressivement pour s'établir à la valeur nominale qui dépend de la configuration machine, schématisée par la charge RL. Cette tension VS est représentée schématiquement sur la figure 3. La tension VS est stabilisée au bout d'un temps TD, qui correspond à la période d'initialisation. Lorsque, la machine est mise sous-tension, le contenu du compteur est égal à zéro, car il avait été remis à zéro au moment, de l'arrêt de la machine, en conséquence la sortie du convertisseur 10 est égale à zéro, de ce fait les tensions VD et VC aux entrées − des comparateurs sont nulles.

Lorsque VS devient différent de zéro pendant la période d'initialisation, les comparateurs 5 et 6 détectent cette condition. Le comparateur 5 fournit donc un signal de commande de comptage sur la ligne 13. Le signal sur la ligne 11, étant au niveau haut, la porte 8 est conditionnée et laisse passer les impulsions d'horloge qui sont appliquées au compteur 9 qui commence à compter.

En conséquence, la tension VD à la sortie du convertisseur augmente ainsi que la tension VC. Le rapport des résistances R1 et R2 est choisi pour que VD = 1,2 VC.

En supposant que la fréquence des signaux d'horloge soit de 10 kHz, et que la période d'initialisation soit de deux secondes, la tension VC sera égale à VS à la fin de la période d'initialisation si bien que la sortie du comparateur 5 devient nulle et la porte ET 8 ne laisse plus passer les signaux d'horloge. Le contenu du compteur 9 est figé si bien que VC reste fixé à la valeur initiale de VS, et le courant de charge se trouve mémorisé.

A la fin de la période d'initialisation TD, (figure 3), la porte ET 17 est conditionnée du fait que l'inverseur fournit un niveau logique haut. En conséquence lorsque la tension VS devient supérieure à la tension de seuil VD soit 1,2 VS, par suite d'un défaut dans la machine, la porte ET 17 détecte cette condition et le signal de commande d'arrêt de l'alimentation est transmis par la porte OU 19.

La tension de seuil qui est toujours égale à 1,2 VS, est auto-ajustable suivant le courant de charge.

Afin d'assurer la protection de la machine pendant la période d'initialisation où la porte ET 17 n'est pas conditionnée et où le seuil de détection n'est pas établi, on utilise un seuil fixe VR qui est fourni par le générateur de tension 16 à l'entrée − du comparateur 7. Dès que la tension VS dépasse ce seuil le comparateur 7 fournit un signal qui est transmis par la porte OU 19 sur la ligne 3 pour provoquer l'arrêt de l'alimentation.

La condition VS (DEFAUT) = 1,2 VC correspond à un courant de défaut IF = 0,2 IL, en effet

$$VS\ (DEFAUT) = RL\ (IL + IF) = 1,2\ RLIL$$
$$donc\ IF = 0,2\ IL$$

Donc, lorsque la charge est minimum IL = 20 A, IF est égal à 4 Ampères seulement et lorsque la charge est maximum, IL = 80 A, IF est égal à 16 Ampères, ce qui est acceptable du fait que IF reste inférieur à 20 Ampères.

Le graphique de la figure 4 permet de faire une comparaison entre les protections assurées par le dispositif de la présente invention et un dispositif de détection à seuil fixe comme décrit en référence à la figure 1. Sur cette courbe le courant de défaut IF est représenté en fonction du courant de charge IL dans les deux cas, détecteur à seuil fixe courbe A, et détecteur à seuil variable de la présente invention, courbe B. Pour un détecteur à seuil fixe on peut voir que le courant IF de défaut varie entre 80 Ampères et 20 Ampères, tandis que pour le détecteur à seuil variable de la présente invention, il varie entre 4 et 16 Ampères. La zone hachurée au-dessus de la droite IF = 20 Ampères étant une zone de protection inadéquate puisque le courant de défaut est toujours supérieur à 20 Ampères, ce qui est inacceptable, on voit que le dispositif de la présente invention permet d'assurer une protection pour toutes les valeurs du courant de charge IL comprises entre 20 et 80 Ampères, contrairement au dispositif de détection à seuil fixe.

En outre, les éléments du circuit de la figure 2 sont des éléments classiques facilement intégrables, donc on peut réaliser le détecteur sous forme de circuits intégrés et ainsi obtenir un dispositif qui est très performant et qui ne tient que très peu de place.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Circuit de détection de courant de défaut à seuil auto-réglable, caractérisé en ce qu'il comprend :
des moyens (RS, 4) pour générer une première tension (VS) proportionnelle au courant dont la valeur de défaut est à détecter ;
des moyens (8, 9, 10,5, R1, R2) qui sont actifs pendant une période d'initialisation pour générer une seconde tension (VC) qui à la fin de la période d'initialisation est égale à la première et pour dériver de ladite seconde tension, une tension de seuil (VD) telle que VD = k VC,
des premiers moyens (6, 17) pour comparer la tension de seuil et la première tension pour fournir après la période d'initialisation, une indication de détection de défaut.

2. Circuit selon la revendication 1, caractérisé en ce qu'il comprend des seconds moyens de comparaison (7) pour comparer la première tension et une tension de référence pour fournir une indication de détection de défaut pendant la période d'initialisation.

3. Circuit selon la revendication 1 ou 2 caractérisé en ce qu'il comprend des moyens (18, 17) pour empêcher la génération de l'indication de détection de défaut par les premiers moyens de comparaison pendant la période d'initialisation.

4. Circuit selon l'une quelconque des revendications 1 à 3 caractérisé en ce que les moyens pour générer la seconde tension (VC) comprennent :
un compteur (9) ayant une entrée de comptage et une entrée de remise à zéro,
des moyens (12, 11, 8) pour amener à l'entrée de comptage du compteur des impulsions d'horloge pendant la durée de la période d'initialisation,
des moyens (5) pour générer un signal de commande de comptage,
un convertisseur numérique analogique (10) recevant en entrée (15) les signaux de sortie du compteur et fournissant en sortie la tension de seuil.

5. Circuit selon la revendication 4, caractérisé en ce que les moyens pour générer la seconde tension (VC) comprennent deux résistances (R1, R2) disposées en série entre la sortie du convertisseur et une seconde tension de référence, la tension VC étant prise au point commun des résistances.

6. Circuit selon la revendication 5 caractérisé en ce que les moyens pour générer le signal de commande de comptage comprennent des troisièmes moyens de comparaison (5), comparant la première tension et la seconde tension (VC) et fournissant le signal de commande de comptage lorsque ladite seconde tension est inférieure à la première.

7. Circuit selon la revendication 6, caractérisé en ce qu'il comprend une porte ET (8) ayant trois entrées la première (11) recevant un signal qui rend la porte active pendant la période d'initialisation et inactive pendant la période de fonctionnement, la seconde (12) recevant le signal d'horloge et la troisième (13) recevant le signal de commande de comptage ; et une sortie connectée à l'entrée du compteur.

8. Circuit selon l'une quelconque des revendications 3 à 7 caractérisé en ce que les moyens pour empêcher la génération de l'indication de défaut pendant la période d'initialisation comprennent une seconde porte ET (17) ayant deux entrées ; la première recevant un signal qui rend cette porte inactive pendant la période d'initialisation et active pendant la période de fonctionnement, la seconde entrée étant connectée à la sortie des premiers moyens de comparaison (6) ; la sortie de ladite porte fournissant l'indication de détection de défaut pendant la période d'initialisation.

9. Circuit selon la revendication précédente caractérisé en ce qu'il comprend une porte OU (19) ayant deux entrées, la première recevant l'indication de détection de défaut fournie par les seconds moyens de comparaison (7) et la seconde recevant l'indication fournie par la seconde porte ET (17), et générant en sortie (3) un signal de commande de l'arrêt de l'alimentation.

**Claims**

1. A self-calibrating fault current detecting circuit, characterized in that it includes :

means (RS, 4) for generating a first voltage (VS) which is proportional to the current the fault value of which is to be detected,

means (8, 9, 10, 5, R1, R2) which are active during an initialization cycle for generating a second voltage (VC) which, at the end of the initialization cycle, is equal to the first voltage and for deriving from said second voltage a threshold voltage (VD) such that VD = k VC,

first means (6, 17) for comparing the threshold voltage with the first voltage in order to provide a fault detection indication after the initialization cycle.

2. A circuit according to claim 1, characterized in that it includes second comparison means (7) for comparing the first voltage to a reference voltage in order to provide a fault detection indication during the initialization cycle.

3. A circuit according to claim 1 or 2, characterized in that it includes means (18, 17) to prevent the first comparison means from generating the fault detection indication during the initialization cycle.

4. A circuit according to anyone of claims 1 through 3, caracterized in that the means for generating the second voltage (VC) include :

a counter (9) provided with a counting input and a resetting input,

means (12, 11, 8) for applying clock pulses to the counting input of the counter during the initialization cycle,

means (5) for generating a count control signal, an analog-to-digital converter (10) the input (15) of which receives the output signal of the counter and which provides the threshold voltage.

5. A circuit according to claim 4, characterized in that the means for generating the second voltage (VC) comprise two resistors (R1, R2) mounted in series between the converter output and a second reference voltage, voltage VC being drawn at the common resistor point.

6. A circuit according to claim 5, characterized in that the means for generating the count control signal include third comparison means (5) which compare the first voltage with the second voltage (VC) and provides the count control signal if said second voltage is lower than the first one.

7. A circuit according to claim 6, characterized in that it comprises an AND gate 8 having three inputs, the first input (11) receiving a signal which activates the gate during the initialization cycle and deactivates it during operation time, the second input (12) receiving the clock signal, and the third input (13) receiving the count control signal ; and one output connected to the counter input.

8. A circuit according to anyone of claims 3 through 7, characterized in that the means for preventing the generation of the fault indication during the initialization cycle include a second AND gate (17) having two inputs, the first one receiving a signal which deactivates the gate during the initialization cycle and which activates it during the operation time, the second input being connected to the output of the first comparison means (6), the output of said gate providing the fault detection indication during the initialization cycle.

9. A circuit according to the aforegoing claim, characterized in that it comprises an OR gate (19) having two inputs, the first one receiving the fault detection indication provided by the second comparison means (7), the second one receiving the indication provided by the second AND gate (17), and whose output (3) generates a control signal to stop the power supply.

**Ansprüche**

1. Schaltung zur Fehlerstromermittlung mit selbsteichender Schwelle, dadurch gekennzeichnet, dass sie aufweist :

Mittel (RS, 4) zur Erzeugung einer ersten Spannung (VS), die proportional zu dem Strom, dessen Fehlerwert zu ermitteln ist,

Mittel (8, 9, 10, 5, R1, R2), die während einer Initialisierungszeit inaktiv sind, zur Erzeugung einer zweiten Spannung (VC), die am Ende der Initialisierungszeit der ersten Spannung gleich ist, und zur Ableitung einer Schwellenspannung aus dieser zweiten Spannung, so dass VD = k VC, erste Vergleichsmittel (6, 17) zum Vergleich der Schwellenspannung mit der ersten Spannung, um eine Anzeige der Fehlerermittlung nach der Initialisierungszeit zu geben.

2. Schaltung nach Anspruch 1, dadurch gekennzeichnet, dass sie zweite Vergleichsmittel (7) zum Vergleichen der ersten Spannung mit einer Bezugsspannung aufweist, um eine Anzeige der Fehlerermittlung während der Initialisierungszeit zu geben.

3. Schaltung nach Anspruch 1 oder 2, dadurch gekennzeichnet, dass sie Mittel (18, 17) aufweist, um die Erzeugung der Anzeige der Fehlerermittlung durch die ersten Vergleichsmittel während der Initialisierungszeit zu verhindern.

4. Schaltung nach einem der Ansprueche 1 bis 3, dadurch gekennzeichnet, dass die Mittel zur Erzeugung der zweiten Spannung (VC) aufweisen :

einen Zähler (9) mit einem Zähleingang und einem Rückstelleingang, Mittel (12, 11, 8) um dem Zähleingang des Zählers während der Dauer der Initialisierungszeit Taktimpulse anzulegen, Mittel (5) zur Erzeugung eines Steuersignals für die Zählung, einen digital-analogen Wandler (10), an dessen Eingang (15) Ausgangssignale des Zählers zugeführt werden, und der an seinem Ausgang die Schwellenspannung abgibt.

5. Schaltung nach Anspruch 4, dadurch gekennzeichnet, dass die Mittel zur Erzeugung der zweiten Spannung (VC) zwei zwischen dem Ausgang des Wandlers und der zweiten Bezugsspannung hintereinandergeschaltete Widerstände (R1, R2) aufweisen, wobei die Spannung (VC) an dem gemeinsamen Punkt der Widerstaende entnommen ist.

6. Schaltung nach Anspruch 5, dadurch gekennzeichnet, dass die Mittel zur Erzeugung des Steuersignals für die Zählung dritte Vergleichsmittel (5) aufweisen, die die erste Spannung mit der zweiten Spannung (VC) vergleichen und das Steuersignal für die Zählung abgeben, wenn die zweite Spannung unter der ersten Spannung liegt.

7. Schaltung nach Anspruch 6, dadurch gekennzeichnet, dass sie eine UND-Torschaltung (8) mit drei Eingängen, wobei dem ersten Eingang (11) ein Signal, das die Torschaltung aktiv während der Initialisierungszeit und inaktiv während der Betriebszeit macht, dem zweiten Eingang (12) das Taktsignal und dem dritten Eingang (13) das Steuersignal für die Zählung zugeführt ist, und einen mit dem Eingang des Zählers verbundenen Ausgang aufweist.

8. Schaltung nach einem der Ansprueche 3 bis 7, dadurch gekennzeichnet, dass die Mittel zum Verhindern der Erzeugung der Fehleranzeige während der Initialisierungszeit eine zweite UND-Torschaltung (17) mit zwei Eingängen aufweisen, wobei dem ersten Eingang ein Signal zugeführt ist, das diese Torschaltung inaktiv während der Initialisierungszeit und aktiv während der Betriebszeit macht, und der zweite Eingang mit dem Ausgang der ersten Vergleichsmittel (6) verbunden ist ; wobei der Ausgang dieser Torschaltung die Anzeige der Fehlerermittlung während der Initialisierungszeit gibt.

9. Schaltung nach dem vorhergehenden Anspruch, dadurch gekennzeichnet, dass sie eine ODER-Torschaltung (19) mit zwei Eingaengen aufweist, wobei dem ersten Eingang die von den zweiten Vergleichsmitteln (7) gegebene Anzeige der Fehlerermittlung und dem zweiten Eingang die von der zweiten UND-Torschaltung (17) gegebene Anzeige zugeführt ist, wobei ein Steuersignal fuer die Abschaltung der Stromversorgung am Ausgang (3) dieser ODER-Torschaltung auftritt.

# FIG. 1

IS

2

IF

IL RL RF

1

# FIG. 4

A

IF

100

AMPERES 80

60

40

20

ZONE DE
PROTECTION
INADEQUATE

B

20 80

IL AMPERES

# FIG. 2

# FIG. 3